# EUROPEAN PATENT SPECIFICATION

(11) **EP 2 669 806 B1**
(45) Date of publication and mention of the grant of the patent: **04.07.2018**
(21) Application number: 12739769.3
(22) Date of filing: 18.01.2012
(51) Int. Cl.: G06F 12/00, G06F 3/06, G11C 15/00, G06F 17/30

(54) **STORAGE SYSTEM**
SPEICHERSYSTEM
SYSTÈME DE MÉMORISATION

(30) Priority: 28.01.2011 JP 2011016230
(43) Date of publication of application: 04.12.2013
(73) Proprietor: NEC Corporation, Tokyo 108-8001 (JP); NEC Solution Innovators, Ltd., Tokyo 136-8627 (JP)
(72) Inventor: GU, Jiajun, Tokyo 108-8001 (JP); WATANABE, Noriyuki, Tokyo 136-8627 (JP); KAWAKITA, Tomoya, Tokyo 136-8627 (JP)
(74) Representative: Vossius & Partner Patentanwälte Rechtsanwälte mbB
(86) International application number: PCT/JP2012/000253
(87) International publication number: WO 2012/101983

(56) References cited:
- WO-A1-2010/086922
- US-A1- 2003 182 253
- US-A1- 2008 294 696
- US-B1- 6 643 654

## Description

### TECHNICAL FIELD

The present invention relates to a storage system, more specifically, relates to a content-addressable storage system which specifies a storage location to store data by using a unique address specified in accordance with the content of the stored data.

### BACKGROUND ART

In recent years, various kinds of information are digitalized in accordance with development and spread of computers. A device for storing such digital data is, for example, a storage device such as a magnetic tape and a magnetic disk. Because data to be stored increases day by day and reaches a huge amount, a mass storage is needed. Moreover, it is required to keep reliability while reducing the cost spent for a storage device. In addition, it is also required to be capable of easily retrieving data later. Thus, a storage system is expected to be capable of automatically realizing increase of storage capacity and performance, eliminating duplicated storage to reduce storage cost, and working with high redundancy.

Under such circumstances, a content-addressable storage system has been developed in recent years as shown in Patent Document 1. In this content-addressable storage system, data is distributed and stored into a plurality of storage devices, and a storage location where the data is stored is specified by a unique content address specified in accordance with the content of the data. To be specific, in a content-addressable storage system, given data is divided into a plurality of fragments and a fragment of redundant data is added thereto, and these fragments arc stored into a plurality of storage devices, respectively.

Thus, later, it is possible by designating a content address to retrieve data, namely, fragments stored in storage locations specified by the content address and restore the given data before division from the fragments.

Further, the content address is generated so as to be unique in accordance with the content of the data. For example, a hash value of the data is used. Thus, regarding duplicated data, it is possible by referring to data in the same storage location to acquire data of the same content. Consequently, it is unnecessary to separately store duplicated data, and it is possible to eliminate duplicated recording and reduce data capacity.

Further, in a content-addressable storage system, a tree-like file system is used. This is a system in which a content address referring to stored data is referred to by a content address located in a higher layer and thereby the contents addresses are stored in a tree structure. Thus, by tracing a reference destination of a content address from a higher layer to a lower layer, it is possible to access a target stored data.

Patent Document 1: Japanese Unexamined Patent Application Publication No. 2010-157204 US 2008/294 696 A1 refers to a system and method for "on-the-fly" de-duplication of data before storing the data in a storage system.

In general, when copying a file in a file system, there is a need to execute a process of once retrieving all file data to be copied from storage and rewriting into a file of a copy destination. This causes a problem that an execution time of a copy process increases in proportion to the size of a file, namely, the amount of data and the performance of a storage system is lowered by frequently executing the process.

When copying a file in the abovementioned content-addressable storage system, the abovementioned problem that it takes time to copy also arises. That is to say, in order to copy data, it is required to execute a process of firstly specifying and retrieving data to be copied based on a content address and restoring the data from the fragments, and moreover, it is required to execute a process of deduplication of already stored data. Therefore, the problem that it takes time to execute the copy process still arises.

### SUMMARY

Accordingly, an object of the present invention is to solve the abovementioned problem that it takes time to execute the data copy process.

### BRIEF DESCRIPTION OF DRAWINGS

Fig. 1 is a diagram showing the configuration of a storage system and the aspect of storage and reference of data in a first exemplary embodiment of the present invention;
Fig. 2 is a diagram showing the aspect of data stored into a CAS unit disclosed in Fig. 1;
Fig. 3 is a diagram showing the aspect of data stored into the CAS unit disclosed in Fig. 1;
Fig. 4 is a diagram showing the aspect of data stored into the CAS unit disclosed in Fig. 1:
Fig. 5 is a diagram showing the aspect of data stored into the CAS unit disclosed in Fig. 1;
Fig. 6 is a diagram showing the aspect of data stored into the CAS unit disclosed in Fig. 1;
Fig. 7 is a diagram showing the configuration of a storage system in a second exemplary embodiment of the present invention;
Fig. 8 is a diagram showing the aspect of data stored into a CAS unit disclosed in Fig. 7;
Fig. 9 is a diagram showing the aspect of data stored into the CAS unit disclosed in Fig. 7; and
Fig. 10 is a diagram showing the configuration of a storage system in Supplementary Note 1 of the present invention.

### EXEMPLARY EMBODIMENTS

### <First Exemplary Embodiment>

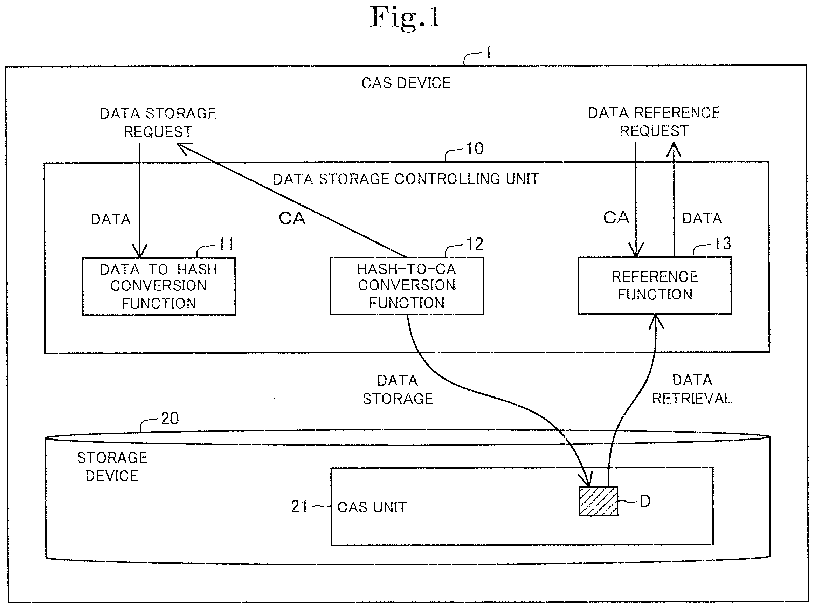

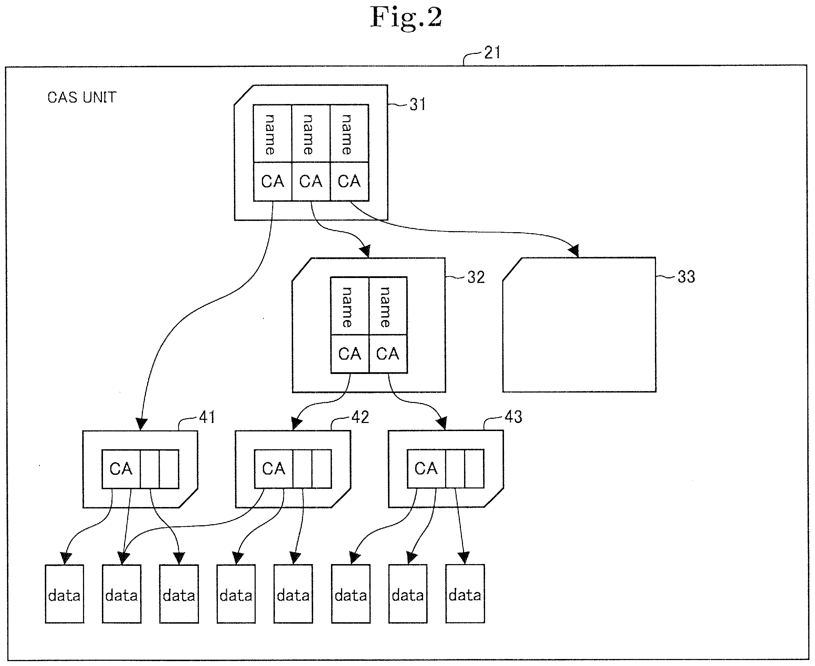

A first exemplary embodiment of the present invention will be described with reference to Figs. 1 to 6. Fig. 1 is a diagram showing the configuration of a storage system and the aspect of storage and reference of data. Figs. 2 to 6 are diagrams showing the aspect of data stored into a CAS unit formed in a storage device.

First, the storage system in this exemplary embodiment is a so-called content-addressable storage system in which data is distributed and stored into a plurality of storage devices and a storage location where the data is stored is specified by a unique content address specified in accordance with the content of the data.

A content-addressable storage system 1 is configured by one or more information processing devices provided with an arithmetic device (not shown) and a storage device 20 and, as shown in Fig. 1, includes a data storage controlling unit 10 built by installation of a program into the arithmetic device. Then, the data storage controlling unit 10 has a function (a data-to-hash conversion function 11) of obtaining a hash value from (part of) data to be stored, and has a function (a hash-to-CA conversion function 12) of converting the obtained hash value into address data (referred to as a "CA (content address)" hereinafter) representing a storage location of the physical storage device 20 previously made to correspond by a fixed rule. The hash-to-CA conversion function 12 returns a CA (content address) when storing data D. Moreover, the data storage controlling unit 10 has a reference function 13 to retrieve the data D referred to by the CA from the physical storage device 20. A region in the physical storage device 20 secured for a CA is referred to as a CAS unit 21.

Thus, in a case that, at the time of storing a file or another CA into the storage device 20, the newly stored file or other CA has the same data content as data already stored in the storage device 20, the data storage controlling unit 10 makes it possible to refer to the data already stored in the storage device 20 as the newly stored file or other CA by using the CA, and has an effect of eliminating duplicated recording.

Next, an example of the structure of a file system generated by the aforementioned content-addressable storage system 1 will be described with reference to Fig. 2. So-called metadata for managing the file system and actual file data are divided into blocks as necessary, and stored into the CAS unit 21. That is to say, the blocks stored into the CAS unit 21 can store divided data of file data and a CA (content address) representing a storage location of another block. Thus, a logical tree structure is generated in the CAS unit 21.

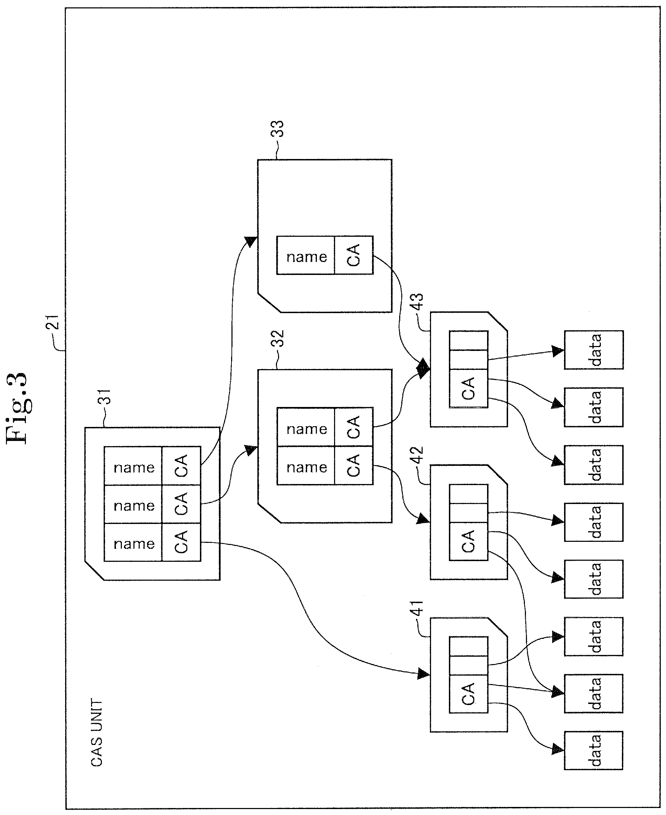

For example, when storing a certain file into a content-address storage system, there is a need to divide the file data into blocks (when necessary), store the blocks obtained by division into the CAS unit 21, and manage the thus obtained CAs. A structure of managing a plurality of CAs referring to a plurality of blocks obtained by dividing a file shall be referred to as a "file management structure" (file management structure data), and stored into the CAS unit 21 as denoted by reference numerals 41, 42 and 43. Moreover, a storage location of the file within the file system is referred to as a directory, and a structure of managing a file stored in the directory and a CA referring to the file management directory is referred to as "a directory management structure" (directory management structure data). The directory management structure is stored into the CAS unit 21 as denoted by reference numerals 31, 32 and 33 in Fig. 3, for example. To the directory management structure, a name of a file to be referred to and a CA of a file management structure referring to the file, or a name of a directory to be referred to and a CA of a directory management structure of the directory are related.

The content-addressable storage system 1 according to the present invention has a function of copying a file already stored in the CAS unit 21. To be specific, the data storage controlling unit 10 in this exemplary embodiment copies a file by acquiring the aforementioned "file management structure" that is address data of a file to be copied (an address data acquiring unit), and generating and setting up a copy of this "file management structure" in the CAS unit 21 (an address data set-up unit). In a content-addressable storage system, it is possible to copy in the abovementioned manner because data of the same content is stored into the same address.

For example, in an example shown in Fig. 3, by copying a CA of a file management structure denoted by reference numeral 43 stored in a copy source directory management structure denoted by reference numeral 32 into a copy destination directory management structure 33 denoted by reference numeral 33, it is possible to copy data configuring a file stored in the CA stored in the file management structure denoted by the reference numeral 43. At this moment, because the amount of data in the CA in the file management structure 43 is sufficiently small amount of data regardless of the size of the file data, it is possible to copy the file in a short time.

The file copying described above can also be considered as follows. It is assumed that, in the same manner as in general file copy, data of a file existing in a file system of a certain content-addressable storage system is retrieved and newly stored as another file into the CAS unit. At this moment, the data is divided into blocks in the same manner as already stored data blocks, and stored into the CAS unit 21. Then, all CAs obtained by storage of the data become the same as a CA managed by a tile management structure of the retrieved file. Therefore, when this file management structure is stored into the CAS unit, the same CA as the CA of the file management structure of the retrieval source file already stored is obtained. A tree structure formed by adding a correspondence between the obtained CA of the file management structure and the name of the file to the directory structure of the storage destination and storing into the CAS unit is consequently identical to the tree structure obtained by copying the CA described above. As apparent from this, copying the CA of a file management structure into a copy destination directory management structure has an effect equivalent to that of copying the whole file designated by the file management structure.

As described in a second exemplary embodiment later, owing to a feature such that a content-addressable storage system is unconscious of a file system of an address reference source, a method of copying the CA of a file management structure into a copy destination directory management structure conceptually allows copy of a file into another file system as well as copy of a file within one file system. A general file system, because an address space for storing file data is closed within the file system, needs loading and writing data when copying a file into another file system. On the other hand, a content-addressable storage system according to the present invention has a storage destination of a file management structure within the content-addressable storage system and has a function of copying the CA of a file management structure into a directory management structure of another file system, thereby being capable of instantly generating a copy of a file without loading or writing the data even if a copy source directory and a copy destination directory are in different file systems.

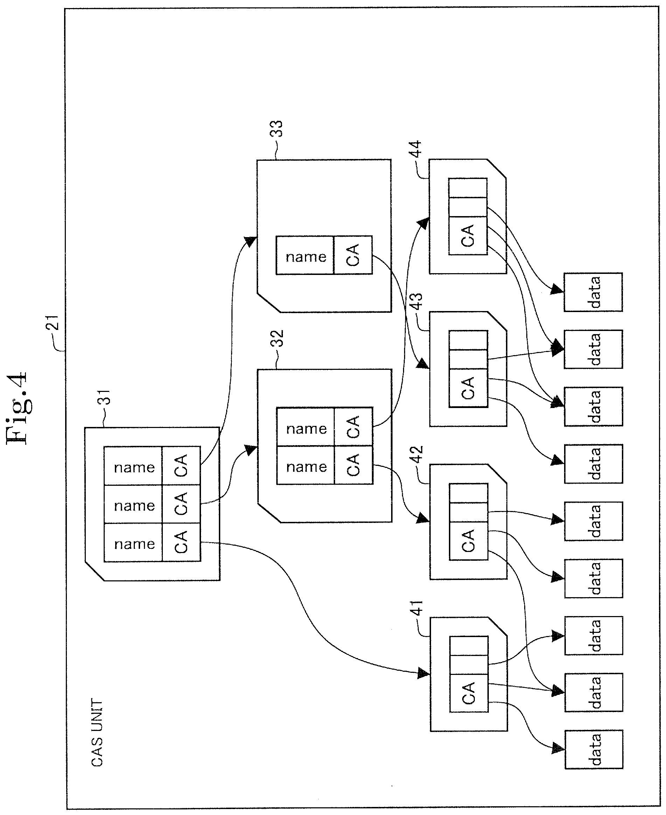

Under a condition that two files stored in directories specified by directory management structures 32 and 33 designate the CA of one file management structure 43 as described with reference to Fig. 3, a case of updating the file of one (32) of the directories will be considered. Fig. 4 shows a state after the file of the one directory (32) is updated. By update of file data, a file management structure 44 is newly generated, and the updated file indicates the CA of the new file management structure 44. This is because the new file management structure 44 includes the CA of the updated file data and therefore is stored into a different CA from the original file management structure. As a result of this operation, the copy source file (43) and the copy destination file (44) are definitely recognized as different files.

The two files generated as described above have a natural structure of sharing only file data that is not updated and not referring to data of the updated portion from one to the other. Moreover, during this operation, nothing of the copy source file management structure is changed. Therefore, there is no need to freeze change of the copy source file.

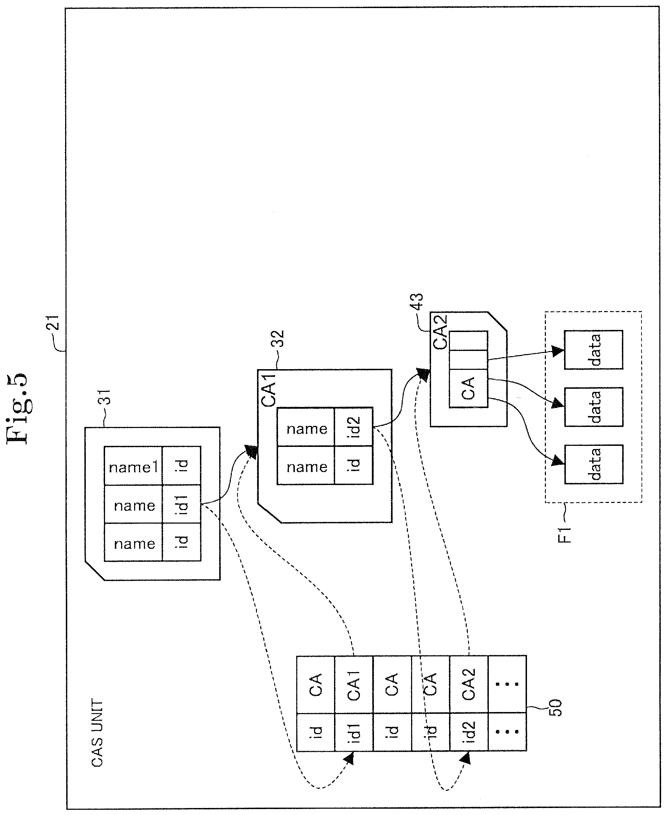

Further, the storage system according to the present invention is configured to prevent the directory management structure 32 from being stored into another CA even when the CAs of the file management structures 43 and 44 are changed as described above. To be specific, the CAS unit 21 in this exemplary embodiment provides a file to be stored and a directory in which the file is stored with identifiers, respectively, and the identifiers are given when the file and the directory are generated and arc not changed until deleted. As shown in Fig. 5, a correspondence map 50 in which an identifier is made to correspond to a CA of a file management structure including the CA of a block (data) of a file provided with the identifier is generated and managed within the CAS unit 21. Moreover, as shown in Fig. 5, in the correspondence map 50, an identifier and the CA of a directory management structure specifying a directory provided with the identifier are made to correspond. Moreover, a directory management structure has a correspondence between a file name and an identifier, instead of a correspondence between the name of a file to be referred to or the name of a file of another directory and a CA.

For example, in the example of Fig. 5, a correspondence between an identifier "id2" of a file F1 and a CA "CA 2" of the file management structure 43 of the file F1 is stored in the correspondence map 50, and the identifier "id2" of the file F1 is referred to by the directory management structure 32. Moreover, a correspondence between an identifier "id1" of a directory of the directory management structure 32 and a CA "CA 1" of the directory management structure 32 is stored in the correspondence map 50, and the identifier "id1" of the directory management structure 32 is referred to by the higher directory management structure 31. Thus, it is possible to refer to a file of a target directory by referring to a CA made to correspond to an identifier of a reference destination stored in the directory management structure 32, 33 in the correspondence map 50 as shown by dotted arrows in Fig. 5.

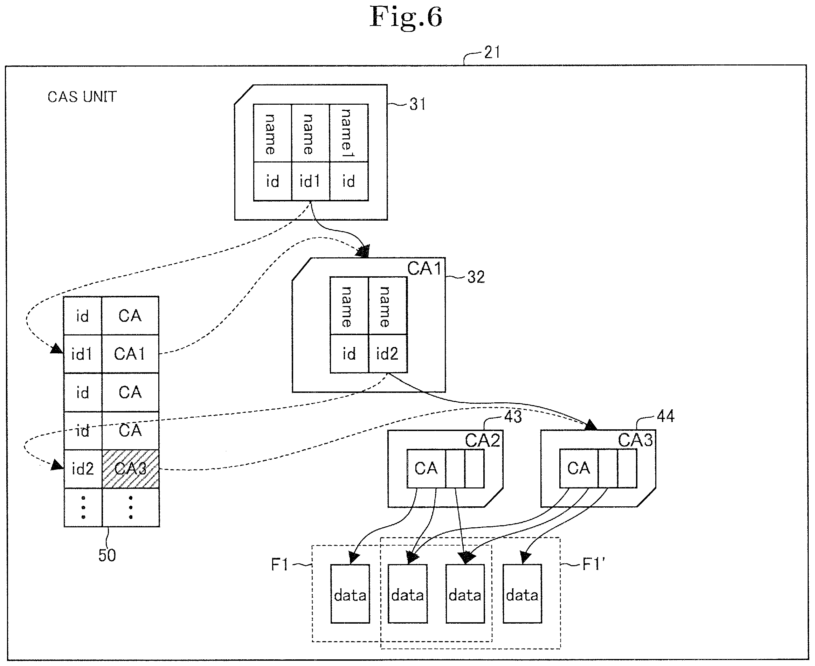

With the configuration described above, it is possible to update a file only by changing the correspondence map 50 of an identifier of the file and a CA without changing a directory management structure. For example, as shown in Fig. 6, at the time of update of the data content of the file F1 to a file F1', the file management structure 43 referring to the file F1 is changed to a new file management structure 44 and, in this case, only the CA made to correspond to the identifier "id2" of the file F1 is changed to a CA "CA 3" of the file management structure 44 (see a shaded part in Fig. 6).

### <Second Exemplary Embodiment>

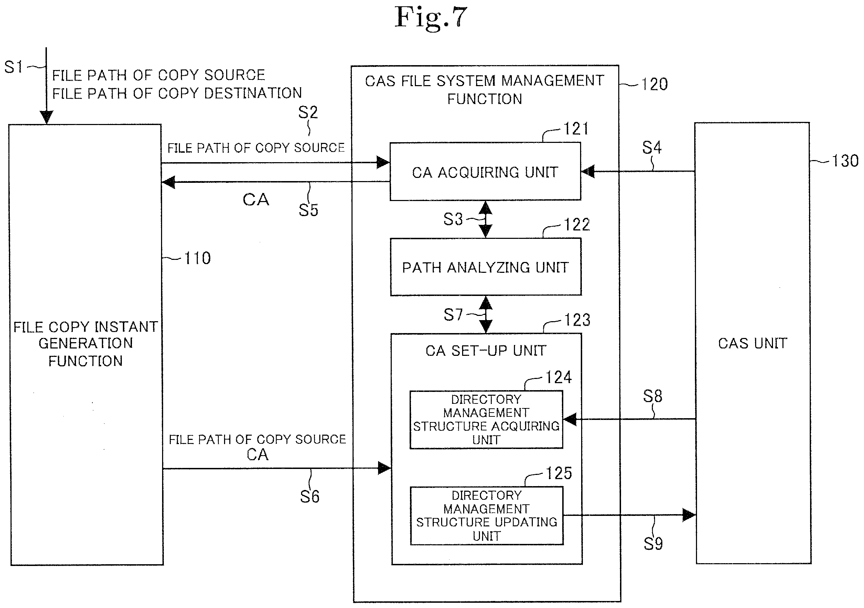

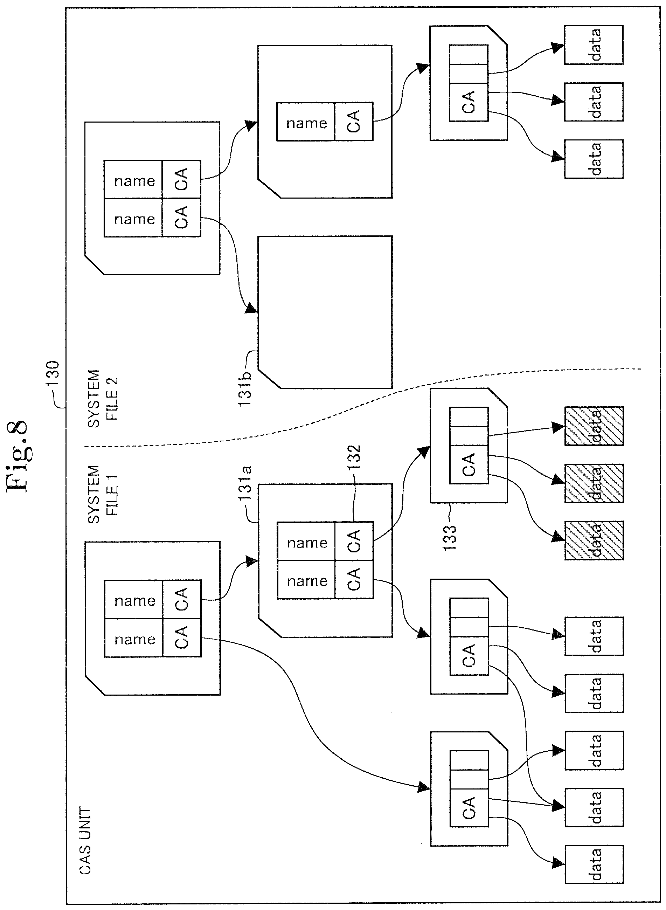

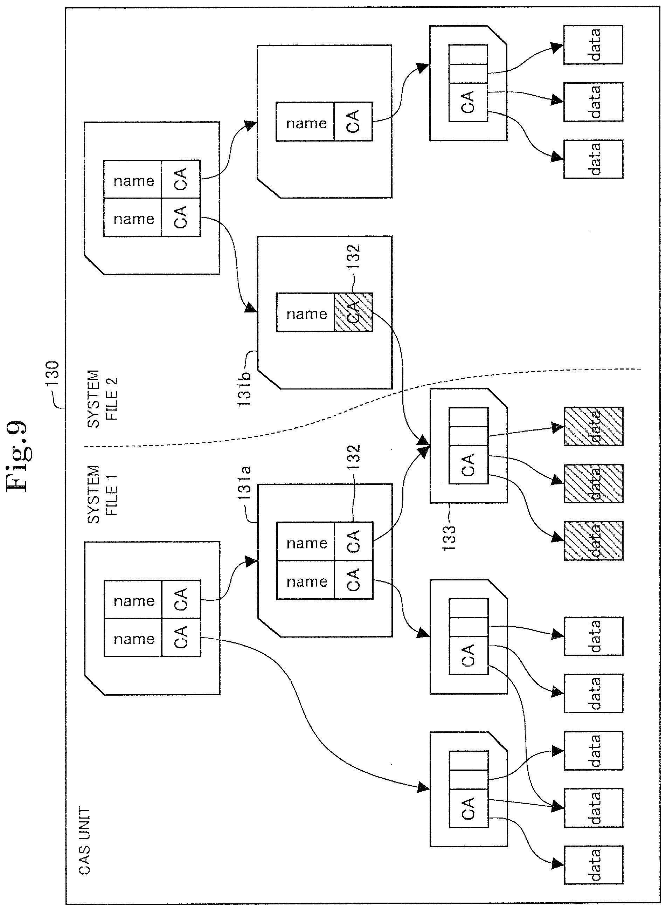

Next, a second exemplary embodiment of the present invention will be described with reference to Figs. 7 to 9. Fig. 7 is a diagram showing the configuration and operation of a storage system in the second exemplary embodiment, and Figs. 8 and 9 are diagrams showing an aspect of copying a file in a CAS unit.

For sake of convenience, it is described that a directory management structure is configured to directly hold a CA, but actually, as described with reference to Fig. 6 in the first exemplary embodiment, an identifier is stored instead of a CA in a directory management structure, and a correspondence map in which the identifier is made to correspond to a CA to be referred to is stored in a CAS unit.

First, a storage system in this exemplary embodiment is configured by one or more information processing devices provided with an arithmetic device and a storage device, as in the first exemplary embodiment described above. This storage system includes a file copy instant generation function 110 and a CAS file system management function 120, which are built by installation of a program in the arithmetic device, as shown in Fig. 7. The CAS file system management function 120 includes a CA acquiring unit 121, a path analyzing unit 122, and a CA set-up unit 123 having a directory management structure acquiring unit 124 and a directory management structure updating unit 125. In the storage device, a CAS unit 130 is formed.

The CAS unit 130 of the storage system in this exemplary embodiment stores a data structure of a content-addressable file system as shown in Fig. 8, and stores two file systems, namely, a file system 1 and a file system 2. The number of the file systems stored in the CAS unit 130 is not limited to two, and more file systems may be stored. The CAS file system management function 120 (a data storage controlling unit) has a function of performing management for each of the file systems. Below, the operation of the storage system will be described with reference to Figs. 7 to 9.

First, as shown in Fig. 7, when a file copy request is made, the file copy instant generation function 110 accepts inputs of a copy source file path (file specification information (path information)) representing a storage location of a file to be copied and a copy destination file path representing a storage location of a copy destination file (S1 in Fig. 7). Then, the file copy instant generation function 110 passes the copy source file path to the CA acquiring unit 121 of the CAS file system management function 120 that manages data of the file system 1 (S2 in Fig. 7).

The CA acquiring unit 121 (an address data acquiring unit) analyzes the copy source file path by using the path analyzing unit 122 (S3 in Fig. 7), and retrieves a CA 132 (see Fig. 8) within a directory management structure 131a indicating a file data management structure 133 referring to files (shaded "data" shown in Fig. 8) designated by the path from the CAS unit 130 (S4 in Fig. 7). Then, the CA acquiring unit 121 returns the retrieved CA 132 to the file copy generation function 110 (S5 in Fig. 7).

Subsequently, the file copy instant generation function 110 passes the returned CA 132 and the copy destination file path to the CA set-up unit 123 of the CAS file system management function 120 that manages data of the file system 2 (S6 in Fig. 7).

The CA set-up unit 123 (an address data set-up unit) analyzes the copy destination file path by using the path analyzing unit 122 (S7 in Fig. 7), and acquires a CA of a directory management structure 131b (see Fig. 9) designated by the path. Then, the CA set-up unit 123 passes the CA of the directory management structure 131b as an input to the directory management structure acquiring unit 124. The directory management structure acquiring unit 124 retrieves the directory management structure 131b corresponding to the passed CA from the CAS unit 130 (S8 in Fig. 7), and returns to the CA set-up unit 123.

Subsequently, the CA set-up unit 123 passes the directory management structure 131b as an input to the directory management structure updating unit 125. The directory management structure updating unit 125 adds a correspondence between a file name and the CA 132 to the directory management structure 131b (see a shaded part in Fig. 9), and writes and returns the updated directory management structure 131b to the CAS unit 130 (S9 in Fig. 7).

Thus, the CA132 indicating the file management structure 133 belonging to the file system 1 is copied into the directory management structure 131b belonging to the file system 2, and consequently, copy of the file from the file system 1 to the file system 2 is completed.

Accordingly, the storage system of the present invention can realize instant copy of a file without input/output of a large amount of data regardless of the size of a file. Moreover, the storage system of the present invention can copy a file between two file systems existing on the same content-addressable storage system.

Although path information of a file is used as an input into the file copy instant generation function 110 in the above description, key information (the name of a file system) specifying a file system and a file identifier given to a file may be used as information for specifying a copy source file and a copy destination file. From such information, firstly, the CA acquiring unit 121 can specify a storage location of a file of a copy source and acquire a CA of the file of the copy source, and the CA set-up unit 123 can specify a file located in a directory of a copy destination and locate so as to refer to the acquired CA instead of the file, thereby copying a file. Consequently, even when path information of a file copy destination is not disclosed, it is possible to copy a file as far as the name of a file system and an identifier are disclosed. A file of a copy destination shall be generated in advance, and any data may be therein (the file may be empty).

<Supplementary Notes>

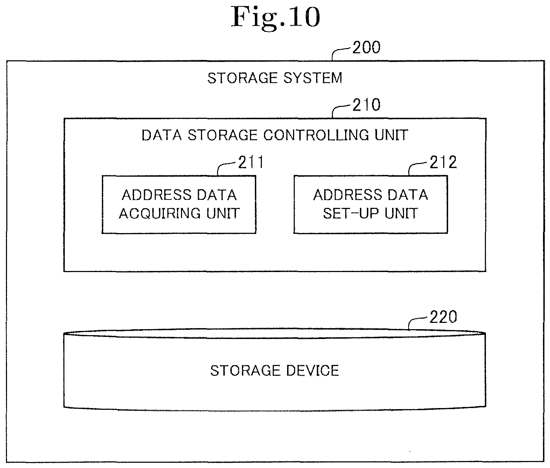

The whole or part of the exemplary embodiments disclosed above can be described as the following supplementary notes. Below, the outline of the configuration of the storage system in the present invention will be described with reference to Fig. 10. However, the present invention is not limited to the following configurations.

### (Supplementary Note 1)

A storage system 200 including:
a storage device 220 for storing division data configuring a file and also storing address data based on a data content and storage location of a reference destination, the address data referring to the division data or other address data; and
a data storage controlling unit 210 for, in a case that the division data or the other address data is to be newly stored into the storage device, and the division data or the other address data to be newly stored has a same data content as data already stored in the storage device, controlling to refer to the data already stored in the storage device as the division data or the other address data to be newly stored, by using the address data,
wherein the data storage controlling unit 210 includes an address data acquiring unit 211 for accepting file specification information that specifies a copy target file stored in the storage device and acquiring the address data of the copy target file based on the file specification information, and an address data set-up unit 212 for setting up the acquired address data in the storage device so that the copy target file is stored in a copy destination directory.

### (Supplementary Note 2)

The storage system according to Supplementary Note 1, wherein:
the storage device is configured to store file management structure data storing a plurality of address data referring to a plurality of the division data configuring the file and also store directory management structure data storing address data referring to the file management structure data and specifying a directory that is a storage location of the file stored in a reference destination of the address data;
the address data acquiring unit is configured to specify the file management structure data storing address data referring to division data configuring the copy target file based on the file specification information, and acquire address data referring to the file management structure data; and
the address data set-up unit is configured to copy the address data acquired by the address data acquiring unit into the directory management structure data specifying a directory located in a copy destination of the copy target file.

### (Supplementary Note 3)

The storage system according to Supplementary Note 2, wherein:
the storage device is configured to store a correspondence map that makes an identifier given to the each file correspond to address data of the file management structure data referring to the file, and also store the identifier given to the file referred to by the address data, as the address data referring to the file management structure data in the directory management structure data; and
the data storage controlling unit is configured to refer to the file based on the identifier stored as the address data in the directory management structure data and based on the correspondence map.

### (Supplementary Note 4)

The storage system according to Supplementary Note 3, wherein the storage device is configured to: store the directory management structure data storing address data referring to other directory structure management data and also store, into the correspondence map, a correspondence map that makes an identifier given to the each directory correspond to address data of the directory management structure data specifying the directory; and store, as the address data referring to the other directory structure management data in the directory management structure data, the identifier given to the directory referred to by the address data.

### (Supplementary Note 5)

The storage system according to Supplementary Note 3 or 4, wherein the data storage controlling unit is configured to, when changing a data content of the file, change the address data made to correspond to the identifier of the directory in the correspondence map.

### (Supplementary Note 6)

The storage system according to any of Supplementary Notes 1 to 5, wherein the address data acquiring unit is configured to accept path information representing a storage location of the copy target file as the file specification information, and acquire the address data referring to the file specified by the path information.

### (Supplementary Note 7)

The storage system according to any of Supplementary Notes 3 to 5, wherein the address data acquiring unit is configured to accept, as the file specification information, file system specification information specifying a file system storing the copy target file and an identifier of the file, and acquire the address data referring to a file specified by the file system specification information and by the identifier of the file.

### (Supplementary Note 8)

A computer program including instructions for:
causing an information processing device, which is connected to a storage device for storing division data configuring a file and also storing address data based on a data content and storage location of a reference destination, the address data referring to the division data or other address data, to realize a data storage controlling unit for, in a case that the division data or the other address data is to be newly stored into the storage device, and the division data or the other address data to be newly stored has a same data content as data already stored in the storage device, controlling to refer to the data already stored in the storage device as the division data or the other address data to be newly stored, by using the address data; and
causing the data storage controlling unit to realize an address data acquiring unit for accepting file specification information that specifies a copy target file stored in the storage device and acquiring the address data of the copy target file based on the file specification information, and an address data set-up unit for setting up the acquired address data in the storage device so that the copy target file is stored in a copy destination directory.

### (Supplementary Note 9)

The computer program according to Supplementary Note 8, wherein:
the storage device is configured to store file management structure data storing a plurality of address data referring to a plurality of the division data configuring the file and also store directory management structure data storing address data referring to the file management structure data and specifying a directory that is a storage location of the file stored in a reference destination of the address data;
the address data acquiring unit is configured to specify the file management structure data storing address data referring to division data configuring the copy target file based on the file specification information, and acquire address data referring to the file management structure data; and
the address data set-up unit is configured to copy the address data acquired by the address data acquiring unit into the directory management structure data specifying a directory located in a copy destination of the copy target file.

### (Supplementary Note 10)

A data storage method including, by an information processing device connected to a storage device for storing division data configuring a file and also storing address data based on a data content and a storage location of a reference destination, the address data referring to the division data or other address data:
executing a data storage control, in a case that the division data or the other address data is newly stored into the storage device, and the division data or the other address data to be newly stored has a same data content as data already stored in the storage device, to refer to the data already stored in the storage device as the division data or the other address data to be newly stored, by using the address data; and
accepting file specification information that specifies a copy target file stored in the storage device, acquiring the address data of the copy target file based on the file specification information, and setting up the acquired address data in the storage device so that the copy target file is stored in a copy destination directory.

### (Supplementary Note 11)

The data storage method according to Supplementary Note 10, wherein:
by the storage device, storing file management structure data storing a plurality of address data referring to a plurality of the division data configuring the file, and also storing directory management structure data storing address data referring to the file management structure data and specifying a directory that is a storage location of the file stored in a reference destination of the address data;
by the information processing device, specifying the file management structure data storing address data referring to division data configuring the copy target file based on the file specification information, acquiring address data referring to the file management structure data, and copying the address data acquired by the address data acquiring unit into the directory management structure data specifying a directory located in a copy destination of the copy target file.

The program is stored in the storage device or recorded in a computer-readable recording medium in each of the exemplary embodiments described above. For example, the recording medium is a portable medium such as a flexible disk, an optical disk, a magneto-optical disk and a semiconductor memory.

Although the present invention has been described above with reference to the respective exemplary embodiments, the present invention is not limited to the exemplary embodiments described above. The configuration and details of the present invention can be modified in various manners that can be understood by those skilled in the art within the scope of the present invention.

The present invention is based upon and claims the benefit of priority from Japanese patent application No. 2011-016230, filed on January 28, 2011.

### DESCRIPTION OF REFERENCE NUMERALS

- 1: storage system
- 10: data storage controlling unit
- 11: data-to-hash conversion function
- 12: hash-to-CA conversion function
- 13: reference function
- 20: storage device
- 21: CAS unit
- 31-33: directory management structure
- 41-44: file management structure
- 50: correspondence map
- 110: file copy instant generation function
- 120: CAS file system management function
- 121: CA acquiring unit
- 122: path analyzing unit
- 123: CA set-up unit
- 124: directory management structure acquiring unit
- 125: directory management structure updating unit
- 130: CAS unit
- 131a, 131b: directory management structure
- 132: CA
- 133: file management structure
- 200: storage system
- 210: data storage controlling unit
- 211: address data acquiring unit
- 212: address data set-up unit
- 220: storage device

## Claims

1. A storage system (1) comprising:
a storage device (20) for storing division data configuring a file and also storing address data based on a data content and storage location of a reference destination, the address data referring to the division data or other address data; and
a data storage controlling unit (10) for, in a case that the division data or the other address data is to be newly stored into the storage device (20), and the division data or the other address data to be newly stored has a same data content as data already stored in the storage device (20), controlling to refer to the data already stored in the storage device (20) as the division data or the other address data to be newly stored, by using the address data,
wherein the data storage controlling unit (10) includes an address data acquiring unit (211) for accepting file specification information that specifies a copy target file stored in the storage device (20) and acquiring the address data of the copy target file based on the file specification information, and an address data set-up unit (212) for setting up the acquired address data in the storage device (20) so that the copy target file is stored in a copy destination directory, wherein
the storage device (20) is configured to store file management structure data storing a plurality of address data referring to a plurality of the division data configuring the file and also store directory management structure data storing address data referring to the file management structure data and specifying a directory that is a storage location of the file stored in a reference destination of the address data;
the address data acquiring unit (211) is configured to specify the file management structure data storing address data referring to division data configuring the copy target file based on the file specification information, and acquire address data referring to the file management structure data; and
the address data set-up unit (212) is configured to copy the address data acquired by the address data acquiring unit (211) into the directory management structure data specifying a directory located in a copy destination of the copy target file, wherein
the storage device (20) is configured to store a correspondence map that makes an identifier given to the each file correspond to address data of the file management structure data referring to the file, and also store the identifier given to the file referred to by the address data, as the address data referring to the file management structure data in the directory management structure data; and
the data storage controlling unit (10) is configured to refer to the file based on the identifier stored as the address data in the directory management structure data and based on the correspondence map.

2. The storage system (1) according to Claim 1, wherein the storage device (20) is configured to: store the directory management structure data storing address data referring to other directory structure management data and also store, into the correspondence map, a correspondence map that makes an identifier given to the each directory correspond to address data of the directory management structure data specifying the directory; and store, as the address data referring to the other directory structure management data in the directory management structure data, the identifier given to the directory referred to by the address data.

3. The storage system (1) according to Claim 1 or 2, wherein the data storage controlling unit (10) is configured to, when changing a data content of the file, change the address data made to correspond to the identifier of the directory in the correspondence map.

4. The storage system (1) according to any of Claims 1 to 3, wherein the address data acquiring unit (211) is configured to accept path information representing a storage location of the copy target file as the file specification information, and acquire the address data referring to the file specified by the path information.

5. The storage system (1) according to any of Claims 1 to 3, wherein the address data acquiring unit (211) is configured to accept, as the file specification information, file system specification information specifying a file system storing the copy target file and an identifier of the file, and acquire the address data referring to a file specified by the file system specification information and by the identifier of the file.

6. A computer program comprising instructions for:
causing an information processing device, which is connected to a storage device (20) for storing division data configuring a file and also storing address data based on a data content and storage location of a reference destination, the address data referring to the division data or other address data, to realize a data storage controlling unit (10) for, in a case that the division data or the other address data is to be newly stored into the storage device (20), and the division data or the other address data to be newly stored has a same data content as data already stored in the storage device (20), controlling to refer to the data already stored in the storage device (20) as the division data or the other address data to be newly stored, by using the address data; and
causing the data storage controlling unit (10) to realize an address data acquiring unit (211) for accepting file specification information that specifies a copy target file stored in the storage device (20) and acquiring the address data of the copy target file based on the file specification information, and an address data set-up unit (212) for setting up the acquired address data in the storage device (20) so that the copy target file is stored in a copy destination directory;
causing the storage device (20) to store file management structure data storing a plurality of address data referring to a plurality of the division data configuring the file and also store directory management structure data storing address data referring to the file management structure data and specifying a directory that is a storage location of the file stored in a reference destination of the address data;
causing the address data acquiring unit (211) to specify the file management structure data storing address data referring to division data configuring the copy target file based on the file specification information, and acquire address data referring to the file management structure data;
causing the address data set-up unit (212) to copy the address data acquired by the address data acquiring unit (211) into the directory management structure data specifying a directory located in a copy destination of the copy target file;
causing the storage device (20) to store a correspondence map that makes an identifier given to the each file correspond to address data of the file management structure data referring to the file, and also store the identifier given to the file referred to by the address data, as the address data referring to the file management structure data in the directory management structure data; and
causing the data storage controlling unit (10) is configured to refer to the file based on the identifier stored as the address data in the directory management structure data and based on the correspondence map.

7. A data storage method comprising, by an information processing device connected to a storage device (20) for storing division data configuring a file and also storing address data based on a data content and a storage location of a reference destination, the address data referring to the division data or other address data:
executing a data storage control, in a case that the division data or the other address data is newly stored into the storage device (20), and the division data or the other address data to be newly stored has a same data content as data already stored in the storage device (20), to refer to the data already stored in the storage device (20) as the division data or the other address data to be newly stored, by using the address data; and
accepting file specification information that specifies a copy target file stored in the storage device (20), acquiring the address data of the copy target file based on the file specification information, and setting up the acquired address data in the storage device (20) so that the copy target file is stored in a copy destination directory;
storing file management structure data storing a plurality of address data referring to a plurality of the division data configuring the file and also store directory management structure data storing address data referring to the file management structure data and specifying a directory that is a storage location of the file stored in a reference destination of the address data;
specifying the file management structure data storing address data referring to division data configuring the copy target file based on the file specification information, and acquiring address data referring to the file management structure data;
copying the address data acquired by the address data acquiring unit (211) into the directory management structure data specifying a directory located in a copy destination of the copy target file;
storing a correspondence map that makes an identifier given to the each file correspond to address data of the file management structure data referring to the file, and also store the identifier given to the file referred to by the address data, as the address data referring to the file management structure data in the directory management structure data; and
referring to the file based on the identifier stored as the address data in the directory management structure data and based on the correspondence map.

## Patentansprüche

1. Speichersystem (1), welches Folgendes aufweist:
eine Speichervorrichtung (20) zum Speichern von Unterteilungsdaten, die eine Datei konfigurieren, und auch zum Speichern von Adressdaten auf der Grundlage eines Dateninhalts und der Speicherstelle eines Referenzziels, wobei sich die Adressdaten auf die Unterteilungsdaten oder andere Adressdaten beziehen, und
eine Datenspeicher-Steuereinheit (10), um in einem Fall, in dem die Unterteilungsdaten oder die anderen Adressdaten neu in der Speichervorrichtung (20) zu speichern sind und die Unterteilungsdaten oder die anderen Adressdaten, die neu zu speichern sind, den gleichen Dateninhalt wie Daten aufweisen, die bereits in der Speichervorrichtung (20) gespeichert sind, zu steuern, um sich auf die bereits in der Speichervorrichtung (20) gespeicherten Daten als die Unterteilungsdaten oder die anderen neu zu speichernden Adressdaten unter Verwendung der Adressdaten zu beziehen,
wobei die Datenspeicher-Steuereinheit (10) eine Adressdaten-Erfassungseinheit (211) zum Entgegennehmen von Dateispezifikationsinformationen, die eine in der Speichervorrichtung (20) gespeicherte Kopierzieldatei spezifizieren, und zum Erfassen der Adressdaten der Kopierzieldatei auf der Grundlage der Dateispezifikationsinformationen und eine Adressdaten-Einrichtungseinheit (212) zum Einrichten der erfassten Adressdaten in der Speichervorrichtung (20) aufweist, so dass die Kopierzieldatei in einem Kopierzielverzeichnis gespeichert wird, wobei
die Speichervorrichtung (20) dafür ausgelegt ist, Dateibehandlungsstrukturdaten zu speichern, welche mehrere Adressdaten, die sich auf mehrere die Datei konfigurierende Unterteilungsdaten beziehen, speichern, und auch Verzeichnisbehandlungsstrukturdaten zu speichern, welche Adressdaten speichern, die sich auf die Dateibehandlungsstrukturdaten beziehen und ein Verzeichnis spezifizieren, das eine Speicherstelle der in einem Referenzziel der Adressdaten gespeicherten Datei ist,
die Adressdaten-Erfassungseinheit (211) dafür ausgelegt ist, auf der Grundlage der Dateispezifikationsinformationen die Dateibehandlungsstrukturdaten, welche Adressdaten speichern, die sich auf Unterteilungsdaten beziehen, welche die Kopierzieldatei konfigurieren, zu spezifizieren und Adressdaten, die sich auf die Dateibehandlungsstrukturdaten beziehen, zu erfassen, und
die Adressdaten-Einrichtungseinheit (212) dafür ausgelegt ist, die von der Adressdaten-Erfassungseinheit (211) erfassten Adressdaten in die Verzeichnisbehandlungsstrukturdaten zu kopieren, die ein Verzeichnis spezifizieren, das sich in einem Kopierziel der Kopierzieldatei befindet, wobei
die Speichervorrichtung (20) dafür ausgelegt ist, eine Entsprechungskarte zu speichern, die bewirkt, dass eine jeder Datei gegebene Kennung Adressdaten der Dateibehandlungsstrukturdaten, die sich auf die Datei beziehen, entspricht, und auch die der Datei, worauf sich die Adressdaten beziehen, gegebene Kennung als Adressdaten, die sich auf die Dateibehandlungsstrukturdaten beziehen, in den Verzeichnisbehandlungsstrukturdaten zu speichern, und
die Datenspeicher-Steuereinheit (10) dafür ausgelegt ist, sich auf der Grundlage der als Adressdaten in den Verzeichnisbehandlungsstrukturdaten gespeicherten Kennung und auf der Grundlage der Entsprechungskarte auf die Datei zu beziehen.

2. Speichersystem (1) nach Anspruch 1, wobei die Speichervorrichtung (20) dafür ausgelegt ist, Folgendes auszuführen: Speichern der Verzeichnisbehandlungsstrukturdaten, die Adressdaten speichern, welche sich auf andere Verzeichnisstrukturbehandlungsdaten beziehen, und auch Speichern einer Entsprechungskarte, die bewirkt, dass eine jedem Verzeichnis gegebene Kennung Adressdaten der Verzeichnisbehandlungsstrukturdaten, die sich auf das Verzeichnis beziehen, entspricht, in der Entsprechungskarte, und Speichern der Kennung, die dem Verzeichnis gegeben ist, worauf sich die Adressdaten beziehen, als Adressdaten, die sich auf die anderen Verzeichnisstrukturbehandlungsdaten beziehen, in den Verzeichnisbehandlungsstrukturdaten.

3. Speichersystem (1) nach Anspruch 1 oder 2, wobei die Datenspeicher-Steuereinheit (10) dafür ausgelegt ist, die Adressdaten, die der Kennung des Verzeichnisses in der Entsprechungskarte entsprechend gemacht wurden, zu ändern, wenn ein Dateninhalt der Datei geändert wird.

4. Speichersystem (1) nach einem der Ansprüche 1 bis 3, wobei die Adressdaten-Erfassungseinheit (211) dafür ausgelegt ist, Pfadinformationen, die eine Speicherstelle der Kopierzieldatei repräsentieren, als Dateispezifikationsinformationen entgegenzunehmen und die Adressdaten zu erfassen, die sich auf die von den Pfadinformationen spezifizierte Datei beziehen.

5. Speichersystem (1) nach einem der Ansprüche 1 bis 3, wobei die Adressdaten-Erfassungseinheit (211) dafür ausgelegt ist, als Dateispezifikationsinformationen Dateisystemspezifikationsinformationen, die ein Dateisystem spezifizieren, das die Kopierzieldatei speichert, und eine Kennung der Datei entgegenzunehmen und die Adressdaten zu erfassen, die sich auf eine durch die Dateisystemspezifikationsinformationen und durch die Kennung der Datei spezifizierte Datei beziehen.

6. Computerprogramm, welches Befehle aufweist, um Folgendes auszuführen:
Veranlassen einer Informationsverarbeitungsvorrichtung, die mit einer Speichervorrichtung (20) verbunden ist, Unterteilungsdaten, die eine Datei konfigurieren, und auch Adressdaten auf der Grundlage eines Dateninhalts und der Speicherstelle eines Referenzziels zu speichern, wobei sich die Adressdaten auf die Unterteilungsdaten oder andere Adressdaten beziehen, Verwirklichen einer Datenspeicher-Steuereinheit (10), um in einem Fall, in dem die Unterteilungsdaten oder die anderen Adressdaten neu in der Speichervorrichtung (20) zu speichern sind und die Unterteilungsdaten oder die anderen Adressdaten, die neu zu speichern sind, den gleichen Dateninhalt wie Daten aufweisen, die bereits in der Speichervorrichtung (20) gespeichert sind, zu steuern, um sich auf die bereits in der Speichervorrichtung (20) gespeicherten Daten als die Unterteilungsdaten oder die anderen neu zu speichernden Adressdaten unter Verwendung der Adressdaten zu beziehen, und
Veranlassen der Datenspeicher-Steuereinheit (10), eine Adressdaten-Erfassungseinheit (211), um Dateispezifikationsinformationen, die eine in der Speichervorrichtung (20) gespeicherte Kopierzieldatei spezifizieren, entgegenzunehmen und die Adressdaten der Kopierzieldatei auf der Grundlage der Dateispezifikationsinformationen zu erfassen, und eine Adressdaten-Einrichtungseinheit (212) zum Einrichten der erfassten Adressdaten in der Speichervorrichtung (20), so dass die Kopierzieldatei in einem Kopierzielverzeichnis gespeichert wird, zu verwirklichen,
Veranlassen der Speichervorrichtung (20), Dateibehandlungsstrukturdaten, welche mehrere Adressdaten, die sich auf mehrere die Datei konfigurierende Unterteilungsdaten beziehen, speichern, und auch Verzeichnisbehandlungsstrukturdaten, welche Adressdaten speichern, die sich auf die Dateibehandlungsstrukturdaten beziehen und ein Verzeichnis spezifizieren, das eine Speicherstelle der in einem Referenzziel der Adressdaten gespeicherten Datei ist, zu speichern,
Veranlassen der Adressdaten-Erfassungseinheit (211), die Dateibehandlungsstrukturdaten, welche Adressdaten speichern, die sich auf Unterteilungsdaten beziehen, welche die Kopierzieldatei konfigurieren, auf der Grundlage der Dateispezifikationsinformationen zu spezifizieren und Adressdaten, die sich auf die Dateibehandlungsstrukturdaten beziehen, zu erfassen,
Veranlassen der Adressdaten-Einrichtungseinheit (212), die von der Adressdaten-Erfassungseinheit (211) erfassten Adressdaten in die Verzeichnisbehandlungsstrukturdaten zu kopieren, die ein Verzeichnis spezifizieren, das sich in einem Kopierziel der Kopierzieldatei befindet,
Veranlassen der Speichervorrichtung (20), eine Entsprechungskarte, die veranlasst, dass eine jeder Datei gegebene Kennung Adressdaten der Dateibehandlungsstrukturdaten, die sich auf die Datei beziehen, entspricht, und auch die der Datei, worauf sich die Adressdaten beziehen, gegebene Kennung als Adressdaten, die sich auf die Dateibehandlungsstrukturdaten beziehen, in den Verzeichnisbehandlungsstrukturdaten zu speichern, und
Veranlassen, dass die Datenspeicher-Steuereinheit (10) dafür ausgelegt wird, sich auf der Grundlage der als Adressdaten in den Verzeichnisbehandlungsstrukturdaten gespeicherten Kennung und auf der Grundlage der Entsprechungskarte auf die Datei zu beziehen.

7. Datenspeicherverfahren, wobei durch eine Informationsverarbeitungsvorrichtung, die mit einer Speichervorrichtung (20) zum Speichern von Unterteilungsdaten, die eine Datei konfigurieren, verbunden ist, worin auch Adressdaten auf der Grundlage eines Dateninhalts und einer Speicherstelle eines Referenzziels gespeichert sind, wobei sich die Adressdaten auf die Unterteilungsdaten oder andere Adressdaten beziehen, Folgendes ausgeführt wird:
Ausführen einer Datenspeichersteuerung, um sich in einem Fall, in dem die Unterteilungsdaten oder die anderen Adressdaten neu in der Speichervorrichtung (20) gespeichert werden und die Unterteilungsdaten oder die anderen Adressdaten, die neu zu speichern sind, den gleichen Dateninhalt wie Daten aufweisen, die bereits in der Speichervorrichtung (20) gespeichert sind, auf die bereits in der Speichervorrichtung (20) gespeicherten Daten als die Unterteilungsdaten oder die anderen neu zu speichernden Adressdaten unter Verwendung der Adressdaten zu beziehen, und
Entgegennehmen von Dateispezifikationsinformationen, die eine in der Speichervorrichtung (20) gespeicherte Kopierzieldatei spezifizieren, Erfassen der Adressdaten der Kopierzieldatei auf der Grundlage der Dateispezifikationsinformationen und Einrichten der erfassten Adressdaten in der Speichervorrichtung (20), so dass die Kopierzieldatei in einem Kopierzielverzeichnis gespeichert wird,
Speichern von Dateibehandlungsstrukturdaten, welche mehrere Adressdaten, die sich auf mehrere die Datei konfigurierende Unterteilungsdaten beziehen, speichern, und auch Verzeichnisbehandlungsstrukturdaten speichern, die Adressdaten, die sich auf die Dateibehandlungsstrukturdaten beziehen, speichern und ein Verzeichnis spezifizieren, das eine Speicherstelle der in einem Referenzziel der Adressdaten gespeicherten Datei ist,
Spezifizieren der Dateibehandlungsstrukturdaten, welche Adressdaten speichern, die sich auf Unterteilungsdaten beziehen, welche die Kopierzieldatei konfigurieren, auf der Grundlage der Dateispezifikationsinformationen und Erfassen von Adressdaten, die sich auf die Dateibehandlungsstrukturdaten beziehen,
Kopieren der von der Adressdaten-Erfassungseinheit (211) erfassten Adressdaten in die Verzeichnisbehandlungsstrukturdaten, die ein Verzeichnis spezifizieren, das sich in einem Kopierziel der Kopierzieldatei befindet,
Speichern einer Entsprechungskarte, die veranlasst, dass eine jeder Datei gegebene Kennung Adressdaten der Dateibehandlungsstrukturdaten, die sich auf die Datei beziehen, entspricht, und auch Speichern der Kennung, die der Datei gegeben ist, worauf sich die Adressdaten beziehen, als Adressdaten, die sich auf die Dateibehandlungsstrukturdaten beziehen, in den Verzeichnisbehandlungsstrukturdaten und
Bezugnehmen auf die Datei auf der Grundlage der als Adressdaten in den Verzeichnisbehandlungsstrukturdaten gespeicherten Kennung und auf der Grundlage der Entsprechungskarte.

## Revendications

1. Système de stockage (1) comprenant :
un dispositif de stockage (20) pour stocker des données de division configurant un fichier et stocker également des données d'adresse d'après un contenu de données et un emplacement de stockage d'une destination de référence, les données d'adresse faisant référence aux données de division ou autres données d'adresse ; et
une unité de commande de stockage de données (10) pour, dans un cas où les données de division ou les autres données d'adresse doivent être stockées à nouveau dans le dispositif de stockage (20), et les données de division ou les autres données d'adresse à stocker à nouveau ont un même contenu de données que des données déjà stockées dans le dispositif de stockage (20), commander de se référer aux données déjà stockées dans le dispositif de stockage (20) en tant que données de division ou autres données d'adresse à stocker à nouveau, en utilisant les données d'adresse,
dans lequel l'unité de commande de stockage de données (10) comporte une unité d'acquisition de données d'adresse (211) pour accepter des informations de spécification de fichier qui spécifient un fichier cible de copie stocké dans le dispositif de stockage (20) et acquérir les données d'adresse du fichier cible de copie d'après les informations de spécification de fichier, et une unité d'installation de données d'adresse (212) pour installer les données d'adresse acquises dans le dispositif de stockage (20) de sorte que le fichier cible de copie soit stocké dans un répertoire de destination de copie, dans lequel
le dispositif de stockage (20) est configuré pour stocker des données de structure de gestion de fichier stockant une pluralité de données d'adresse faisant référence à une pluralité des données de division configurant le fichier et stocker également des données de structure de gestion de répertoire stockant des données d'adresse faisant référence aux données de structure de gestion de fichier et spécifiant un répertoire qui est un emplacement de stockage du fichier stocké dans une destination de référence des données d'adresse ;
l'unité d'acquisition de données d'adresse (211) est configurée pour spécifier les données de structure de gestion de fichier stockant des données d'adresse faisant référence à des données de division configurant le fichier cible de copie d'après les informations de spécification de fichier, et acquérir des données d'adresse faisant référence aux données de structure de gestion de fichier ; et
l'unité d'installation de données d'adresse (212) est configurée pour copier les données d'adresse acquises par l'unité d'acquisition de données d'adresse (211) dans les données de structure de gestion de répertoire spécifiant un répertoire situé dans une destination de copie du fichier cible de copie, dans lequel
le dispositif de stockage (20) est configuré pour stocker une carte de correspondance qui fait correspondre un identifiant donné à chaque fichier à des données d'adresse des données de structure de gestion de fichiers faisant référence au fichier, et stocker également l'identifiant donné au fichier auquel font référence les données d'adresse, en tant que données d'adresse faisant référence aux données de structure de gestion de fichier dans les données de structure de gestion de répertoire ; et
l'unité de commande de stockage de données (10) est configurée pour se référer au fichier d'après l'identifiant stocké en tant que données d'adresse dans les données de structure de gestion de répertoire et d'après la carte de correspondance.

2. Système de stockage (1) selon la revendication 1, dans lequel le dispositif de stockage (20) est configuré pour : stocker les données de structure de gestion de répertoire stockant des données d'adresse faisant référence à d'autres données de gestion de structure de répertoire et stocker également, dans la carte de correspondance, une carte de correspondance qui fait correspondre un identifiant donné à chaque répertoire à des données d'adresse des données de structure de gestion de répertoire spécifiant le répertoire ; et stocker, en tant que données d'adresse faisant référence aux autres données de gestion de structure de répertoire dans les données de structure de gestion de répertoire, l'identifiant donné au répertoire auquel font référence les données d'adresse.

3. Système de stockage (1) selon la revendication 1 ou 2, dans lequel l'unité de commande de stockage de données (10) est configurée pour, lors du changement d'un contenu de données du fichier, changer les données d'adresse amenées à correspondre à l'identifiant du répertoire dans la carte de correspondance.

4. Système de stockage (1) selon l'une quelconque des revendications 1 à 3, dans lequel l'unité d'acquisition de données d'adresse (211) est configurée pour accepter des informations de trajet représentant un emplacement de stockage du fichier cible de copie en tant qu'informations de spécification de fichier, et acquérir les données d'adresse faisant référence au fichier spécifié par les informations de trajet.

5. Système de stockage (1) selon l'une quelconque des revendications 1 à 3, dans lequel l'unité d'acquisition de données d'adresse (211) est configurée pour accepter, en tant qu'informations de spécification de fichier, des informations de spécification de système de fichier spécifiant un système de fichier stockant le fichier cible de copie et un identifiant du fichier, et acquérir les données d'adresse faisant référence à un fichier spécifié par les informations de spécification de système de fichier et par l'identifiant du fichier.

6. Programme d'ordinateur comprenant des instructions pour :
amener un dispositif de traitement d'informations, qui est connecté à un dispositif de stockage (20) pour stocker des données de division configurant un fichier et stocker également des données d'adresse d'après un contenu de données et un emplacement de stockage d'une destination de référence, les données d'adresse faisant référence aux données de division ou à d'autres données d'adresse, à réaliser une unité de commande de stockage de données (10) pour, dans un cas où les données de division ou les autres données d'adresse doivent être stockées à nouveau dans le dispositif de stockage (20), et les données de division ou les autres données d'adresse à stocker à nouveau ont un même contenu de données que des données déjà stockées dans le dispositif de stockage (20), commander de se référer aux données déjà stockées dans le dispositif de stockage (20) en tant que données de division ou autres données d'adresse à stocker à nouveau, en utilisant les données d'adresse ; et
amener l'unité de commande de stockage de données (10) à réaliser une unité d'acquisition de données d'adresse (211) pour accepter des informations de spécification de fichier qui spécifient un fichier cible de copie stocké dans le dispositif de stockage (20) et acquérir les données d'adresse du fichier cible de copie d'après les informations de spécification de fichier, et une unité d'installation de données d'adresse (212) pour installer les données d'adresse acquises dans le dispositif de stockage (20) de sorte que le fichier cible de copie soit stocké dans un répertoire de destination de copie ;
amener le dispositif de stockage (20) à stocker des données de structure de gestion de fichier stockant une pluralité de données d'adresse faisant référence à une pluralité des données de division configurant le fichier et stocker également des données de structure de gestion de répertoire stockant des données d'adresse faisant référence aux données de structure de gestion de fichier et spécifiant un répertoire qui est un emplacement de stockage du fichier stocké dans une destination de référence des données d'adresse ;
amener l'unité d'acquisition de données d'adresse (211) à spécifier les données de structure de gestion de fichier stockant des données d'adresse faisant référence à des données de division configurant le fichier cible de copie d'après les informations de spécification de fichier, et acquérir des données d'adresse faisant référence aux données de structure de gestion de fichier ;
amener l'unité d'installation de données d'adresse (212) à copier les données d'adresse acquises par l'unité d'acquisition de données d'adresse (211) dans les données de structure de gestion de répertoire spécifiant un répertoire situé dans une destination de copie du fichier cible de copie ;
amener le dispositif de stockage (20) à stocker une carte de correspondance qui fait correspondre un identifiant donné à chaque fichier à des données d'adresse des données de structure de gestion de fichier faisant référence au fichier, et stocker également l'identifiant donné au fichier auquel font référence les données d'adresse, en tant que données d'adresse faisant référence aux données de structure de gestion de fichier dans les données de structure de gestion de répertoire ; et
amener l'unité de commande de stockage de données (10) à se référer au fichier d'après l'identifiant stocké en tant que données d'adresse dans les données de structure de gestion de répertoire et d'après la carte de correspondance.

7. Procédé de stockage de données comprenant, par un dispositif de traitement d'informations connecté à un dispositif de stockage (20) pour stocker des données de division configurant un fichier et stocker également des données d'adresse d'après un contenu de données et un emplacement de stockage d'une destination de référence, les données d'adresse faisant référence aux données de division ou à d'autres données d'adresse :
l'exécution d'une commande de stockage de données, dans le cas où les données de division ou les autres données d'adresse sont stockées à nouveau dans le dispositif de stockage (20), et les données de division ou les autres données d'adresse à stocker à nouveau ont un même contenu de données que des données déjà stockées dans le dispositif de stockage (20), pour se référer aux données déjà stockées dans le dispositif de stockage (20) en tant que données de division ou autres données d'adresse à stocker à nouveau, en utilisant les données d'adresse ; et
l'acceptation d'informations de spécification de fichier qui spécifient un fichier cible de copie stocké dans le dispositif de stockage (20), l'acquisition des données d'adresse du fichier cible de copie d'après les informations de spécification de fichier, et l'installation des données d'adresse acquises dans le dispositif de stockage (20) de sorte que le fichier cible de copie soit stocké dans un répertoire de destination de copie ;
le stockage de données de structure de gestion de fichier stockant une pluralité de données d'adresse faisant référence à une pluralité des données de division configurant le fichier et le stockage également de données de structure de gestion de répertoire stockant des données d'adresse faisant référence aux données de structure de gestion de fichier et la spécification d'un répertoire qui est un emplacement de stockage du fichier stocké dans une destination de référence des données d'adresse ;
la spécification des données de structure de gestion de fichier stockant des données d'adresse faisant référence à des données de division configurant le fichier cible de copie d'après les informations de spécification de fichier, et l'acquisition de données d'adresse faisant référence aux données de structure de gestion de fichier ;
la copie des données d'adresse acquises par l'unité d'acquisition de données d'adresse (211) dans les données de structure de gestion de répertoire spécifiant un répertoire situé dans une destination de copie du fichier cible de copie ;
le stockage d'une carte de correspondance qui fait correspondre un identifiant donné à chaque fichier à des données d'adresse des données de structure de gestion de fichier faisant référence au fichier, et le stockage également de l'identifiant donné au fichier auquel font référence les données d'adresse, en tant que données d'adresse faisant référence aux données de structure de gestion de fichier dans les données de structure de gestion de répertoire ; et
le fait de se référer au fichier d'après l'identifiant stocké en tant que données d'adresse dans les données de structure de gestion de répertoire et d'après la carte de correspondance.
